# EUROPÄISCHE PATENTSCHRIFT

(11) **EP 1 290 926 B1**
(45) Veröffentlichungstag und Bekanntmachung des Hinweises auf die Patenterteilung: **08.04.2015**
(21) Anmeldenummer: 01913824.7
(22) Anmeldetag: 21.02.2001
(51) Int. Cl.: H05H 1/46, H01J 37/32

(54) **HOCHFREQUENZ-PLASMAQUELLE**
HIGH FREQUENCY PLASMA SOURCE
SOURCE DE PLASMA HAUTE FREQUENCE

(30) Priorität: 24.02.2000 DE 10008482; 24.02.2000 DE 10008483; 24.02.2000 DE 10008484; 24.02.2000 DE 10008485; 24.02.2000 DE 10008486
(43) Veröffentlichungstag der Anmeldung: 12.03.2003
(73) Patentinhaber: CCR GmbH Beschichtungstechnologie, 53619 Rheinbreitbach (DE)
(72) Erfinder: WEILER, Manfred, 53619 Rheinbreitbach (DE); DAHL, Roland, 53545 Ockenfels (DE)
(74) Vertreter: Von Rohr Patentanwälte Partnerschaft mbB
(86) Internationale Anmeldenummer: PCT/EP2001/001952
(87) Internationale Veröffentlichungsnummer: WO 2001/063981

(56) Entgegenhaltungen:
- EP-A- 0 597 497
- WO-A-99/44219
- US-A- 4 948 259
- US-A- 4 994 711
- US-A- 5 858 477
- PATENT ABSTRACTS OF JAPAN vol. 015, no. 277 (E-1089), 15. Juli 1991 (1991-07-15) & JP 03 095843 A (NEC CORP), 22. April 1991 (1991-04-22)

## Beschreibung

Die Erfindung betrifft eine Vorrichtung zur effizienten Anregung einer Niederdruck Gasentladung (Plasma). Die Vorrichtung stellt einen hoch ionisierten und ladungkompensierten Plasmastrahl bereit, welcher aus einem hochdichten Niederdruck Plasma extrahiert wird. Die Eigenschaften des Plasmastrahls (z. B. Ionenenergie, Ionenstromdichte, Zusammensetzung des Ionenstrahls) können sehr gut kontrolliert und eingestellt werden. Alternativ kann in Verbindung mit einem System zur selektiven Extraktion von Elektronen bzw. Ionen ein negativer bzw. positiver Teilchenstrom extrahiert werden. Insbesondere betrifft die vorliegende Erfindung eine Hochfrequenz-Plasmaquelle gemäß Anspruch 1 sowie deren Verwendung.

Plasmasysteme sind für die Herstellung und Bearbeitung von Festkörpermaterialien in der Hochtechnologie von größter Bedeutung. Besonderes Interesse besteht für Plasmareaktoren, welche quasi-neutrale Plasmastrahlen erzeugen. Diese Plasmareaktoren, im folgenden auch als Plasmaquellen bezeichnet, können in den verschiedensten Anwendungsgebieten der Plasmabearbeitung eingesetzt werden. Dazu zählt die Abscheidung und das Aufwachsen dünner Schichten, das Zerstäuben, das Ätzen, das Reinigen etc. Ein Plasmastrahl besteht zu gleichen Teilen aus positiv geladenen Ionen und (negativ geladenen) Elektronen und ist somit elektrisch neutral. Die Quasi-Neutralität des Plasmastrahls erlaubt die Beschichtung und Oberflächenbehandlung von elektrisch isolierenden Materialien, ohne daß ein zusätzlicher Aufbau zur Neutralisation des Plasmastrahls erforderlich ist.

Aktuelle Anwendungen erfordern oft einen hohen Anteil an Ionen mit präzise einstellbarer Ionenenergie, um die Ausbildung der gewünschten chemischen Bindung sicherzustellen. So ist zur Abscheidung von harten Schichten aus diamant-ähnlichem Kohlenstoff (diamond-like carbon, DLC) oder kubischem Bornitrid ein hochionisierter Plasmastrahl mit Ionenenergien von ungefähr 100 eV erforderlich, um den Anteil der sp3-Bindungen zu maximieren. Ein energetischer Abscheideprozeß ist zum Überschreiten der Nukleationsschwelle ebenso erforderlich wie auch zum Sicherstellen einer geschlossenen, kontinuierlichen Schicht. Die Forderung nach einem möglichst hohen Ionenanteil bedeutet, daß die Plasmen bei niedrigen Drücken, typischerweise unter 10-3 mbar, erzeugt werden. Dies wiederum erfordert die magnetfeld-unterstützte Anregung des Plasmas, um Verluste durch Rekombination an den Wänden des Plasmagefäßes zu vermeiden. Eine effiziente Anregung des Plasmas ist Grundvoraussetzung für eine hohe Plasmadichte und hohe Abscheide- oder Ätzraten, um somit

kurze und kostengünstige Bearbeitungszeiten gewährleisten zu können. Von keiner geringeren Bedeutung ist die Fähigkeit einer Plasmaquelle möglichst große Substratflächen bearbeiten zu können, um ökonomisches Bearbeiten mit hoher Effizienz sicherzustellen.

Es gibt verschiedenartige Systeme zur plasma-gestützten Behandlung von Festkörperoberflächen. Ein Teil dieser Systeme beruht auf der Verwendung von hochfrequenten elektrischen Wechselfeldern zur Erzeugung des Plasmas. Die meisten dieser Systeme haben Kathoden- und Anoden-Platten, wobei die Hochfrequenz-Leistung kapazitiv über die Kathode in das Plasma eingespeist wird. Zwischen den Elektroden bildet sich eine Vorspannung aus, deren Größe von der Elektrodenfläche und der angelegten Hochfrequenz-Amplitude abhängig ist. Um den Ionenbeschuß zu maximieren, wird das Substrat auf der Kathode plaziert. Nachteil der kapazitiv gekoppelten Hochfrequenz-Systeme ist die sehr geringe Plasmadichte, welche sich aus der ineffizienten Einkopplung der Hochfrequenz-Leistung in das Plasma ergibt. Bei typischen Prozeßdrücken im Bereich von 10⁻³ mbar enthält der auf das Substrat einfallende Teilchenstrom lediglich etwa 5 % energetischer Teilchen. Dies reicht für viele praktische Anwendungen, die einen energetischen ionen-dominierten Prozeß erfordern, nicht aus. Ein weiterer Nachteil konventioneller Hochfrequenz-Plasmaquellen ist die breite Ionenenergie-Verteilung. Zusätzlich haben diese Systeme relativ geringe Aufwachsraten, wobei die Leistungsdaten auch noch sehr von den Umgebungsbedingungen abhängen.

Das U.S.-Patent 5,017,835 beschreibt eine Hochfrequenz-Ionenquelle zur Erzeugung von großflächigen Ionenstrahlen, wobei induktiv Hochfrequenzenergie in das Plasma eingekoppelt wird. Diese Quelle nutzt die Elektronen-Zyklotronen-Wellenresonanz-Anregung eines Plasmas in einem rohrförmigen Plasmagefäß, welches zwischen einer Trägerplatte und einer Abschlußplatte eingeklemmt ist. Ein abstimmbarer Zwischenkreis verbindet den Hochfrequenz-Generator mit der Lastkreisspule. Ein schwaches Gleichstrom-Magnetfeld ist dem Plasma überlagert. Ein aus mehreren Elektroden bestehendes ionenoptisches System zur Ionenextraktion ist in der Trägerplatte angeordnet.

Das U.S.-Patent 5,156,703 beschreibt ein Verfahren zur Abtragung und Strukturierung von Oberflächen, zur Herstellung von Oberflächendotierungen und zum Erzeugen von Oberflächenschichten durch Teilchenbeschuß aus einem Plasma. Es wird ein quasi-neutraler Plasmastrahl aus einem durch elektrische und magnetische Felder erzeugten Niederdruckplasma dadurch extrahiert, daß eine Hochfrequenzspannung an eine Extraktionselektrode und eine weitere Elektrode, zwischen denen sich das Niederdruckplasma befindet, angelegt wird. Die Amplitude der zwischen dem Plasma und der Extraktionselektrode abfallenden Hochfrequenzspannung bestimmt die Energie der extrahierten Ionen.

M. Weiter et al. hat in den Applied Physics Letters Vol. 64 (1994), Seiten 2797-2799, und im Physical Review B, Vol. 53 (1996), Seiten 1594-1608, die Abscheidung von amorphem tetraedrisch gebundenem Kohlenwasserstoff mittels einer Plasmaquelle beschrieben, die eine hochfrequente (13.56 MHz), kapazitiv gekoppelte, magnetfeld-unterstützte Plasmaentladung erzeugt. Diese Quelle besteht aus einer großen beweglichen hochfrequenz-gespeisten Elektrode sowie einer kleineren Netz-Elektrode, welche auf Erdpotential geschaltet ist. Dem Plasma wird ein statisches hyperbolisches Magnetfeld überlagert. Zwischen Elektrode, dem Plasma und dem geerdeten Netz bildet sich eine positive Vorspannung aus. Die Elektrode kann vertikal verschoben werden. Dabei ändert sich ihre effektive Fläche und ebenso die sich ausbildende Vorspannung. Somit kann über diese Veränderung die Energie der Ionen eingestellt werden, ohne den Gasdruck oder die eingespeiste Leistung zu verändern. Die Innovation besteht bei dieser Quelle darin, daß die Ionenenergie nicht durch Anlegen einer Spannung an das Substrat, sondern durch eine interne Vorspannung kontrollierbar bzw. einstellbar ist. Wie bei allen kapazitiv gekoppelten Plasmaquellen ist auch bei diesem System die Plasmadichte unterhalb einem Druck von 10⁻³ mbar sehr gering.

Eine verbesserte Version der Plasmaquelle wurde durch M. Weiter et al. in den Applied Physics Letters Vol. 72 (1998), Seiten 1314-1316, beschrieben. Der Plasmastrahl wird durch eine hochfrequente (13.56 MHz), induktiv gekoppelte Plasmaentladung mit einem transversal überlagerten statischen Magnetfeld erzeugt. Die Ionenenergie kann durch Anlegen einer Hochfrequenzamplitude an eine sich hinter dem Plasma befindende Elektrode variiert werden.

Das U.S.-Patent 5,858,477 umfaßt Verfahren und Vorrichtungen zur Herstellung von Verschleißschutzschichten auf Speichermedien durch die Abscheidung von amorphem tetraedrisch gebundenen Kohlenwasserstoff. Eines der Systeme beschreibt eine Plasmaquelle, bei der eine Antenne ein Plasmavolumen umschließt und damit das Plasma durch Hochfrequenz induktiv anregt, eine Koppelelektrode zum Plasmavolumen hin und eine Extraktions-Elektrode über der Öffnung des Plasmavolumens angeordnet ist, die einen Ionenstrahl durch kapazitive Kopplung aus dem Plasma extrahiert. Spulen zur Erzeugung eines rotierenden transversalen Magnetfeldes sind zur Homogenisierung des Plasmastrahls um das Plasmavolumen herum angeordnet.

Die US 4,948,259 A offenbart eine Vorrichtung zum Trockenätzen bzw. Sputtern. Eine Kathode in einem Vakuumraum ist direkt an ein benachbart angeordnetes, festes Anpaßnetzwerk angeschlossen.

Ein Problem bei herkömmlichen Plasmaquellen ist, daß Ionenenergie und Ionenstromdichte nicht unabhängig voneinander einstellbar sind. Ein weiteres Problem bei konventionellen Hochfrequenz-Quellen besteht darin, daß ein separates Hochfrequenz Impedanzanpaßnetzwerk erforderlich ist. Das Hochfrequenz-Anpaßnetzwerk speist hierbei die Leistung des Hochfrequenz-Generators über ein Kabel in die Anregungselektrode ein, woraus sich erhebliche Leistungsverluste ergeben. Darüber hinaus können in üblichen Plasmaquellen die Amplitude der Hochfrequenz-Spannung sowie die Amplitude des Hochfrequenz-Stromes im Hochfrequenz-Anpaßnetzwerk nicht unabhängig voneinander eingestellt werden. Damit können Resonanz-Effekte wie die Elektronen-Zyklotronen-Wellenresonanz oder die Landau-Dämpfung nicht in optimaler Weise genutzt werden.

Der Erfindung liegt die Aufgabe zugrunde, die Vielseitigkeit, Funktionalität und Effizienz einer Plasmaquelle zu erhöhen, d. h. Ionenenergie und Ionenstromdichte unabhängig voneinander kontrollierbar zu machen, gleichzeitig hohe Plasmadichten sowie einen hohen Dissoziations- bzw. Ionisationsgrad bereitzustellen und Leistungsverluste zu verringern.

Die obige Aufgabe wird durch eine Hochfrequenz-Plasmaquelle gemäß Anspruch 1 sowie eine Verwendung gemäß Anspruch 25 gelöst. Vorteilhafte Weiterbildungen sind Gegenstand der Unteransprüche.

Vorzugsweise besteht die Hochfrequenz-Plasmaquelle, die zur Erzeugung eines quasineutralen Plasmastrahls oder eines Ionenstrahls verwendet werden kann, aus einem Trägerelement, auf dem eine Magnetfeldspulenanordnung zur Erzeugung eines transversalen magnetischen Feldes, ein Gasverteilungssystem zum Einlassen des Arbeitsgases in das Plasmavolumen und eine Einheit zur Extraktion eines Plasmastrahls angeordnet sind, wobei sich im Innern der Plasmaquelle zusätzlich ein Hochfrequenz-Anpassnetzwerk zur Einspeisung der Generatorleistung ins Plasma befindet, das üblicherweise aus einem primären Schaltkreis mit einem beliebigen und einem variablen Kondensator und einer Hochfrequenz-Luftspule besteht sowie einem sekundären Schaltkreis mit einem Kondensator, einer Hochfrequenz-Luftspule und mindestens einer Anregungselektrode, wobei die beiden Schaltkreise über den induktiven Fluß der Hochfrequenz-Luftspulen und zusätzlich kapazitiv miteinander gekoppelt sind.

Bei der erfindungsgemäßen Plasmaquelle sind Ionenenergie, Ionenstromdichte, Dissoziations- und Ionisationsgrad unabhängig voneinander einstellbar. Die Quelle nutzt Hochfrequenz (typischerweise 13.56 oder 27.12 MHz) zur Anregung der Gasentladung. Die Hochfrequenz-Leistung wird dabei überwiegend induktiv in ein magnetfeld-unterstütztes Plasma über den Mechanismus der Elektronen-Zyklotronen-Wellenresonanz oder der Landau-Dämpfung in das Plasma eingespeist.

Das Hochfrequenz-Anpaßnetzwerk, das u.a. zur Verringerung von Leistungsverlusten dient, ist integrativer Bestandteil der Plasmaquelle, d.h. es ist im Innern der Quelle angeordnet, so daß kein zusätzliches Anpaßnetzwerk mehr erforderlich ist. Es erlaubt, die Ionenenergie über einen weiten Bereich unabhängig von der Ionenstromdichte einzustellen. Bei Verwendung eines variablen Kondensators im Sekundärkreis kann dies kontinuierlich geschehen. Das Hochfrequenz-Anpaßnetzwerk ist derart gestaltet, daß die unabhängige Kontrolle und Einstellbarkeit der Hochfrequenz-Strom-Amplitude und der Hochfrequenz-Spannungs-Amplitude gewährleistet ist. Dies ermöglicht die präzise Wahl der für den Anregungsmechanismus (ECWR oder Landau) notwendigen Bedingungen, damit das Plasma jeweils mit hoher Effizienz angeregt werden kann. Die erfindungsgemäße Plasmaquelle erzeugt sehr hohe Plasmadichten bis zu 10¹³ cm³, stellt sehr hohe Ionisationsgrade bis zu 50 % bereit und weist sehr hohe Dissoziationsgrade auf, welche im Falle von zwei-atomigen Molekülen, wie z.B. Sauerstoff, Stickstoff oder Wasserstoff bis zu 80 % betragen können. Des weiteren besteht die Möglichkeit, die Ionenenergie unabhängig von der Ionenstromdichte über einen Bereich von 10 bis etwa 1.000 eV kontinuierlich einzustellen. Somit erzeugt die erfindungsgemäße Plasmaquelle einen hoch-ionisierten ladungs-kompensierten Plasmastrahl mit wohldefinierter Charakteristik der Ionenenergie, Ionenstromdichte und Zusammensetzung des Plasmastrahls. Zusätzlich wird die Homogenität wie auch die Partikelfreiheit des Plasmastrahls sichergestellt. Dadurch sind die Langzeitstabilität der Plasmaquelle und damit die Beherrschbarkeit des Prozesses sowie auch sehr lange Standzeiten zwischen den Wartungsintervallen gewährleistet.

Ein derartiges Anpaßnetzwerk ist detailliert in der deutschen Patentanmeldung "Hochfrequenz-Anpaßnetzwerk" mit dem amtlichen Aktenzeichen 100 08 485.0 der Firma CCR GmbH Beschichtungstechnologie beschrieben.

Die Anregungselektrode, die zur kombinierten induktiven sowie kapazitiven Plasmaanregung dient, kann sowohl innerhalb des Vakuums als auch außerhalb angeordnet sein. Sie sollte in Form, Größe und Anordnung der Geometrie des gewünschten Plasmastrahls angepaßt sein. Es können auch mehrere Anregungselektroden verwendet werden, die dann vorzugsweise mit einem Abstand zwischen 10 und 100 mm nebeneinander im Vakuum angeordnet sind. Üblicherweise wird in diesem Fall jede Elektrode über ein eigenes Anpaßnetzwerk und einen separaten Hochfrequenz-Generator gespeist. So besteht die Möglichkeit, in den einzelnen Plasmavolumen unterschiedliche Plasmen zu erzeugen, sowie die Strahleigenschaften dieser Plasmen weitgehend unabhängig voneinander zu kontrollieren und einzustellen.

Es werden nur Anregungselektroden eingesetzt, deren Windungszahl n ≤ 1 ist. Hierdurch wird die Induktivität der Anregungselektrode und damit die Hochfrequenzamplitude, welche zwischen Anregungselektrode und Erde über das Plasma abfällt, minimiert. Dadurch erfolgt die Leistungseinkopplung in das Plasma überwiegend induktiv. Eine kontinuierlich zuschaltbare kapazitive Leistungseinkopplung erfolgt dann über die erfindungsgemäße Verschaltung des Anpaßnetzwerkes.

Üblicherweise werden Anregungselektroden aus Rohr- oder Drahtmaterial angefertigt. Soll die Ionenenergie nun mittels einer kapazitiven Ankopplung an das Plasma erhöht werden, d.h. durch eine zusätzliche Hochfrequenz-Amplitude, die zwischen Anregungselektrode und Erde über dem Plasma angelegt wird, so ist die maximal erreichbare Ionenenergie dennoch recht gering. Höhere Ionenenergien können durch Anregungselektroden aus Rohr- oder Drahtmaterial nicht erreicht werden. Die Randflächen des Plasmavolumens bestehen i.d.R. aus geerdeten wie auch aus hochfrequenzführenden Flächen. Je größer das Verhältnis aus hochfrequenzführender Fläche zu geerdeter Fläche ist, desto höher wird auch die maximal erreichbare Ionenenergie. Die Anregungselektrode wird somit mantel- oder bandförmig ausgeführt, um möglichst viel geerdete Fläche durch hochfrequenzführende zu ersetzen. Die Höhe des Mantels entspricht dabei maximal der Länge des Plasmavolumens. Die Elektrode kann die Form einer Platte oder eines nichtgeschlossenen Mantels haben, wobei dieser Mantel im Schnitt vorzugsweise ringförmig, sektorförmig, quadratisch oder rechteckförmig ist.

Die Leistungseinspeisung in das Plasma erfolgt durch Hochfrequenz. Damit sich die Effizienz der Leistungseinspeisung erhöht, wird üblicherweise dem Plasma und auch der Anregungselektrode ein transversales Magnetfeld zur Resonanzanregung überlagert. Das Magnetfeld kann durch um das Plasmavolumen herum angeordnete Magnetfeldspulen erzeugt werden. Diese können sowohl außerhalb als auch innerhalb des Vakuums angeordnet und der Geometrie des Plasmavolumens angepaßt sein. Werden die Spulen mit Gleichstrom betrieben, ist das Magnetfeld statisch. Beim Betrieb mit Wechselstrom kann durch zeitlich versetzte Ansteuerung nebeneinander liegender Spulen bzw. durch phasenverschobene Ströme eine Rotation des Magnetfeldes um die Längsachse der Plasmaquelle erreicht werden. Das Magnetfeld ist dann dynamisch.

Über die Variation des Magnetfeldes kann wahlweise eine Resonanzanregung des Plasmas über die Erzeugung einer stehenden Welle oder durch die Erfüllung der Resonanzbedingungen für die Landau-Dämpfung durchgeführt werden. Über die Variation der magnetischen Feldstärke im Plasmaraum kann der Brechungsindex n des Plasmas über weite Bereiche, in der Regel zwischen 50 und 500 variiert werden. Zur Erfüllung der Landau-Resonanzbedingung muß die Phasengeschwindigkeit C_{PL} der elektromagnetischen Welle mit der mittleren Geschwindigkeit Vₑ der Plasmaelektronen übereinstimmen. Die Phasengeschwindigkeit wird durch den Brechungsindex und die mittlere Geschwindigkeit der Elektronen über die Elektronentemperatur Tₑ bestimmt. Es muß C_{PL} = Cᵥ/n = (kT_{e/}mₑ)^{1/2} gelten.

Ein stationäres transversales Feld ist über das Plasmavolumen nicht homogen. Daraus ergibt sich eine örtlich unterschiedliche Anregungseffizienz im Plasmavolumen und es resultiert eine örtlich unterschiedliche Plasmadichte. Der extrahierte Plasmastrahl ist demzufolge auch inhomogen. Schlußendlich resultiert z.B. eine Beschichtung mit hohen Schichtdicken-Schwankungen. Die Inhomogenität des transversalen Magnetfeldes bildet sich somit auf dem Substrat ab. Die Homogenität der Anregung kann dadurch optimiert werden, daß ein dynamisches Magnetfeld verwandt wird. Anstatt zwei Magnetfeldspulen (stationär) werden dann mindestens drei Magnetfeldspulen um das Plasmavolumen herum angeordnet. Zum Antreiben der Spulen kann Wechselstrom (f < 100 Hz) eingesetzt werden, und zwar derart, daß die Ströme in zwei nebeneinander (oder hintereinander) liegenden Spulen zueinander phasenverschoben sind. Dadurch wird eine Rotation des Magnetfeldes um die Längsachse der Plasmaquelle erreicht. Diese Rotation des Magnetfeldes führt integriert bzw. summiert über einen Rotations-Zyklus zu einer homogenen Anregung des Plasmas. Zusätzlich findet eine homogenitätsverbessernde Durchmischung des Plasmas statt.

Eine zusätzliche Verbesserung der Homogenität des extrahierten Plasmastrahls wird erreicht, wenn über der innersten Spulen-Lage eine zweite Lage derart angeordnet wird, daß die Mitte einer Spule aus der 2. Lage über den Enden eines Spulenpaares aus der innersten Lage positioniert wird.

Idealerweise sind in der Hochfrequenz-Plasmaquelle Magnetfeldspulen, Anregungselektroden und Gaseinlaßsystem räumlich und geometrisch aufeinander abgestimmt.

Zur Extraktion von elektrisch geladenen Teilchen (in der Regel Ionen und/oder Elektronen) aus dem Plasma kann eine Einheit zur Extraktion eines Plasmastrahls, auch als Extraktionssystem bezeichnet, an der Öffnung des Plasmavolumens angeordnet sein. Im einfachsten Fall kann eine Blende, d.h. eine ebene Platte mit einer Öffnung, verwendet werden, so daß ein Ausströmen des Plasmas gewährleistet ist. Eine Variante besteht in der Verwendung eines Gitters, Netzes oder Drahtgewebes, welches sich auf Erdpotential befindet. Die Energie der aus der Quelle austretenden Ionen ergibt sich damit aus der Differenz von Plasma- und Erdpotential. Das Plasmapotential kann durch die Hochfrequenzamplitude des an der Anregungselektrode anliegenden elektrischen Wechselfeldes variiert werden. Es kann somit die kinetische Energie der Ionen durch die Hochfrequenz-Spannungsamplitude variiert werden.

Im folgenden wird die Erfindung beispielhaft anhand von Zeichnungen verdeutlicht:
- Figur 1: zeigt den schematischen Aufbau der Plasmaquelle
- Figuren 2 a - j: zeigen mögliche Formen und Anordnungen von Anregungselektroden
- Figuren 3 a - c: zeigen einen Schnitt durch eine Anregungselektrode
- Figuren 4 a - n: zeigen mögliche Formen und Anordnungen von Magnetfeldspulen
- Figur 5: zeigt die Ionenstromdichte als Funktion der magnetischen Feldstärke zur Darstellung der Landau-Dämpfungsresonanz
- Figuren 6 a, b: zeigen verschiedene Anordnungen eines Plasmastrahl-Extraktionssystems

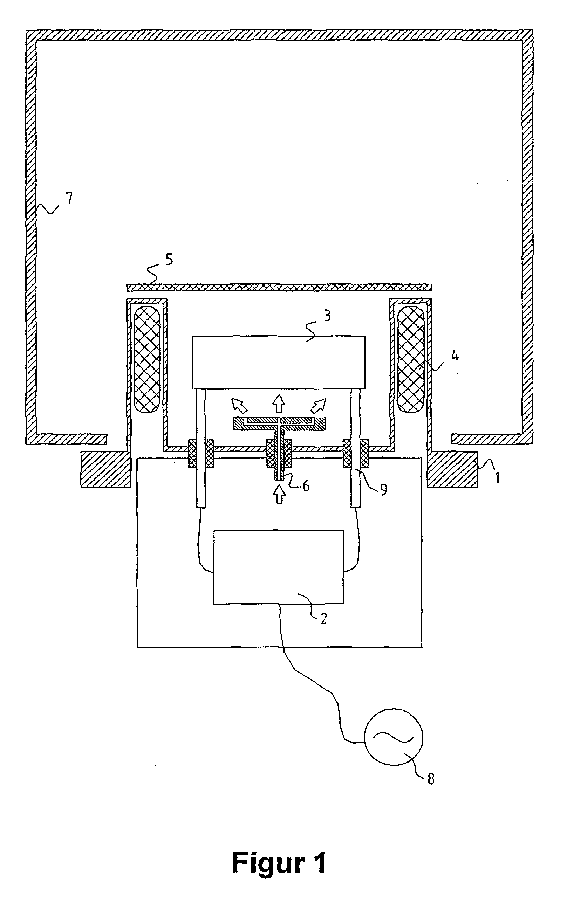

Der prinzipielle Aufbau der Plasmaquelle ist in Figur 1 dargestellt. Die Plasmaquelle setzt sich aus verschiedenen Hauptkomponenten zusammen. Sie besteht aus einem Trägerelement (1), auf dem eine Anordnung mehrerer Magnetfeld-Spulen (4) zur Erzeugung eines transversalen Magnetfeldes, eine Einheit zur Extraktion eines Plasmastrahls (5) und einem Gasverteilungssystem (6) angeordnet sind. Außerdem befindet sich im Innern der Plasmaquelle, ebenfalls mit dem Trägerelement (1) verbunden, ein Hochfrequenz-Anpaßnetzwerk (2) zur Impedanzanpassung mit dazugehöriger Anregungselektrode (3) zur Erzeugung des Plasmas. Die Anregungselektrode (3) ist im Vakuum angeordnet und über Vakuumstromdurchführungen (9) mit dem Hauptteil des Anpaßnetzwerks verbunden. Das Arbeitsgas wird über das Gasverteilungssystem (6) durch die Plasmaquelle hindurch in das Plasmavolumen eingelassen. Die Plasmaquelle stellt in zusammengebautem Zustand und nach Abstimmung aller Komponenten eine kompakte Einheit dar, die an die Gehäusewand eines Vakuumgefäßes (7) angeflanscht werden kann. Zur Leistungseinspeisung ist ein Hochfrequenz-Generator (8) erforderlich, dessen Frequenz bei 13,56 MHz liegt. Die Ansteuerung der Magnetfeld-Spulen (4) erfolgt derart, daß ein rotierendes Magnetfeld erzeugt wird.

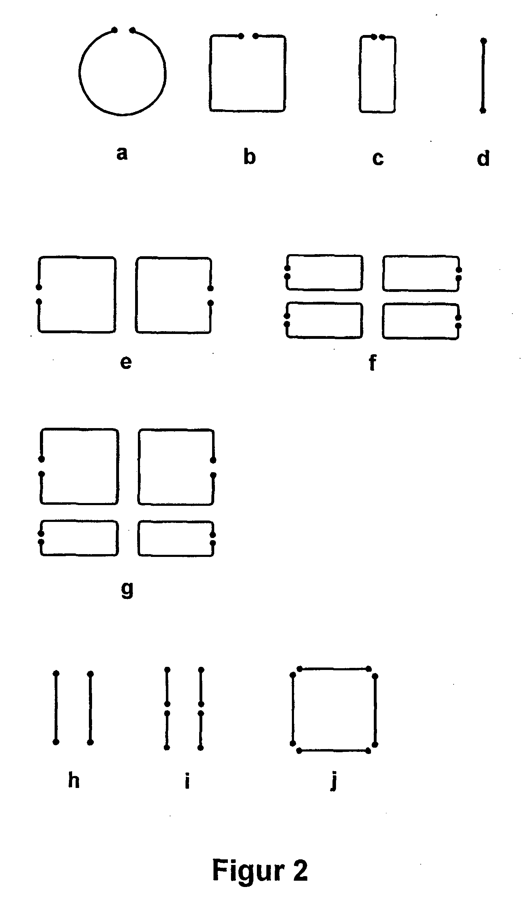

In Figur 2 sind verschiedene Formen und Anordnungen der Anregungselektroden dargestellt. Form und Größe der Anregungselektroden sind dem Querschnitt des gewünschten Plasmastrahls angepaßt. Die sektorförmige Anregungselektrode (Figur 2 a) erzeugt ein rundes Strahlprofil, die quadratische (Figur 2 b) ein quadratisches Strahlprofil. Die rechteckförmige (Figur 2 c) sowie die als Band (Figur 2 d) ausgeführte Anregungselektrode erzeugen ein linienförmiges Strahlprofil. Die beispielhaft beschriebenen Anregungselektroden können in vielfältiger Weise mit nur geringem Abstand von 10 bis 100 mm nebeneinander positioniert werden (Figuren 2e - j).

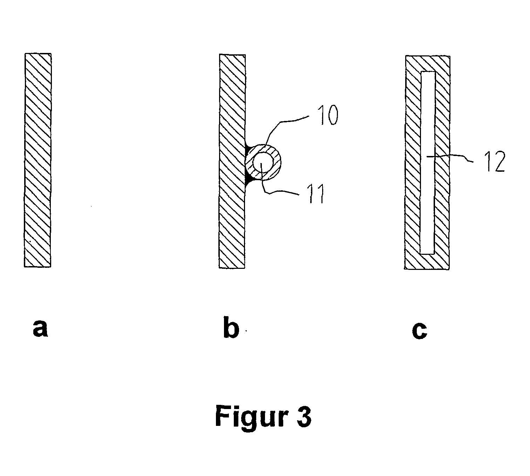

Figur 3 a zeigt eine Schnittdarstellung einer 5 mm breiten und 50 mm hohen mantelförmigen Anregungselektrode. Figur 3b zeigt eine Variante der Anregungselektrode, wobei eine Rohrleitung (10) mit ihr verbunden ist. Figur 3c zeigt eine weitere Variante der Anregungselektrode, wobei diese selbst mit einem Hohlraum (12) versehen ist. Zur Kühlung kann das Innere der Rohrleitung (11) bzw. der Hohlraum (12) mit einem flüssigen Medium, vorzugsweise mit Wasser, durchspült werden.

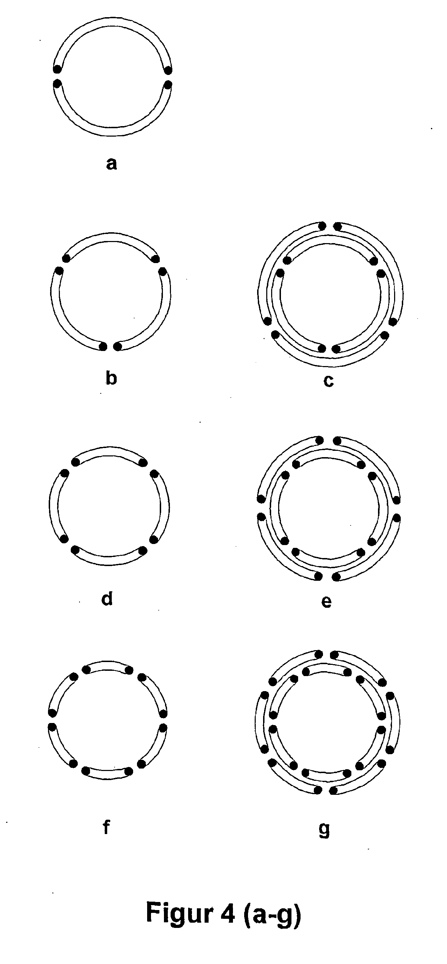

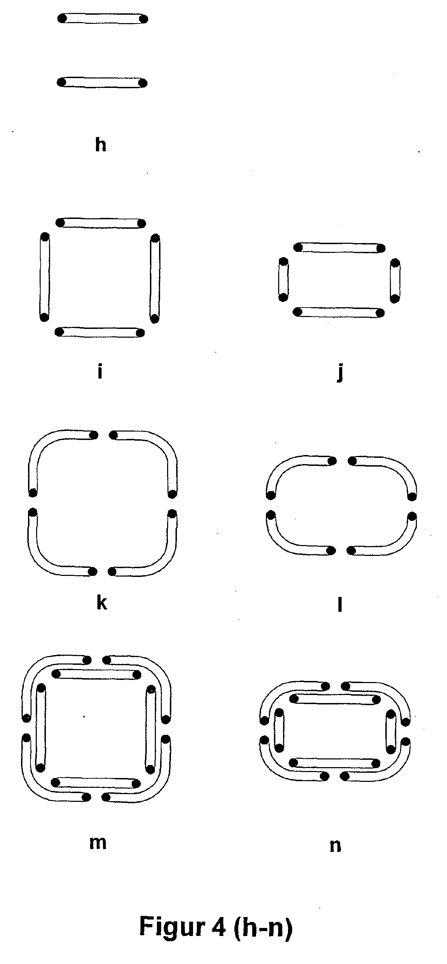

Figur 4 zeigt mögliche Formen und Anordnungen von Magnetfeldspulen zur Erzeugung des transversalen Feldes.

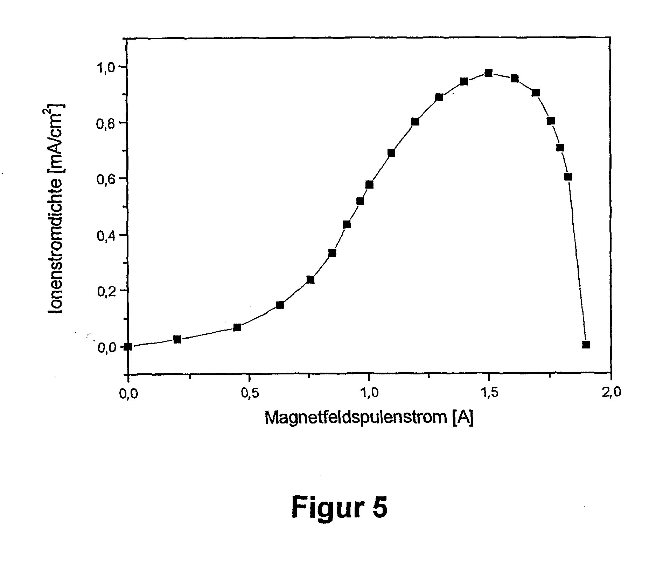

Figur 5 zeigt das Resonanzverhalten der Quelle in der Darstellung der Ionenstromdichte als Funktion des Magnetfeldspulenstromes.

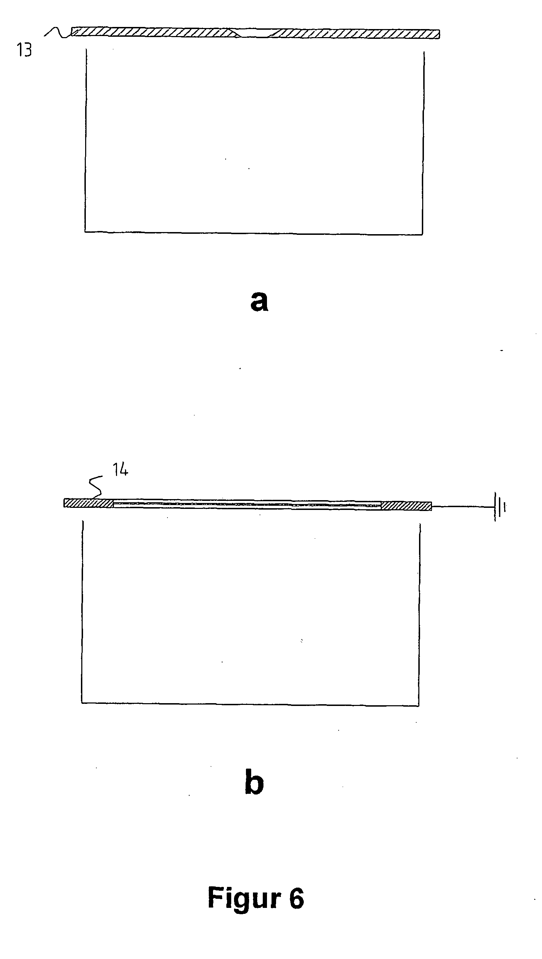

Figur 6 zeigt verschiedene Varianten eines Extraktionssystems. Im einfachsten Fall kann eine ebene Platte mit einer Öffnung (13) verwendet werden (Figur 6a). Figur 6b zeigt ein Drahtgewebe (14), welches sich auf Erdpotential befindet.

### Bezugszeichenliste:

- 1: Trägerelement
- 2: Hochfrequenz-Anpaßnetzwerk
- 3: Anregungselektrode
- 4: Magnetfeldspulenanordnung
- 5: Einheit zur Extraktion eines Plasmastrahls
- 6: Gasverteilungssystem
- 7: Gehäusewand eines Vakuumgefäßes
- 8: Hochfrequenz-Generator
- 9: Vakuumstromdurchführung
- 10: Rohrleitung
- 11: Inneres der Rohrleitung
- 12: Hohlraum der Anregungselektrode
- 13: Lochblende
- 14: Gitter, Netz oder Drahtgewebe

## Patentansprüche

1. Hochfrequenz-Plasmaquelle mit einem Trägerelement (1), auf dem
- eine Magnetfeldspulenanordnung (4),
- ein Gasverteilungssystem (6) und
- eine Einheit zur Extraktion eines Plasmastrahls (5)
angeordnet sind,
**dadurch gekennzeichnet**,
daß sich im Inneren der Plasmaquelle zusätzlich ein Hochfrequenz-Anpaßnetzwerk (2) befindet, wobei zwischen kapazitiver und induktiver Plasmaankopplung gewählt werden kann.

2. Hochfrequenz-Plasmaquelle nach Anspruch 1, **dadurch gekennzeichnet, daß** das Hochfrequenz-Anpaßnetzwerk (2) aus einem primären Schaltkreis mit einem beliebigen und einem variablen Kondensator und einer Hochfrequenz-Luftspule sowie einem sekundären Schaltkreis mit einem Kondensator, einer Hochfrequenz-Luftspule und mindestens einer Anregungselektrode besteht, wobei die Schaltkreise über den induktiven Fluß der Hochfrequenz-Luftspulen und zusätzlich kapazitiv miteinander gekoppelt sind.

3. Hochfrequenz-Plasmaquelle nach einem der Ansprüche 1 oder 2, **dadurch gekennzeichnet, daß** kontinuierlich zwischen kapazitiver und induktiver Plasmaankopplung gewählt werden kann.

4. Hochfrequenz-Plasmaquelle nach einem der Ansprüche 1 bis 3, **dadurch gekennzeichnet, daß** mindestens eine Anregungselektrode (3) im Vakuum angeordnet ist.

5. Hochfrequenz-Plasmaquelle nach einem der Ansprüche 1 bis 4, **dadurch gekennzeichnet, daß** Form, Größe und Anordnung der Anregungselektrode (3) der Geometrie des gewünschten Plasmastrahls angepaßt sind.

6. Hochfrequenz-Plasmaquelle nach einem der Ansprüche 1 bis 5, **dadurch gekennzeichnet, daß** die Anregungselektrode (3) die Form einer Platte hat.

7. Hochfrequenz-Plasmaquelle nach einem der Ansprüche 1 bis 6, **dadurch gekennzeichnet, daß** die Anregungselektrode (3) die Form eines nichtgeschlossenen Mantels hat.

8. Hochfrequenz-Plasmaquelle nach Anspruch 7, **dadurch gekennzeichnet, daß** der nichtgeschlossene Mantel im Schnitt ringförmig ist.

9. Hochfrequenz-Plasmaquelle nach Anspruch 7, **dadurch gekennzeichnet, daß** der nichtgeschlossene Mantel im Schnitt sektorförmig ist.

10. Hochfrequenz-Plasmaquelle nach Anspruch 7, **dadurch gekennzeichnet, daß** der nichtgeschlossene Mantel im Schnitt quadratisch ist.

11. Hochfrequenz-Plasmaquelle nach Anspruch 7, **dadurch gekennzeichnet, daß** der nichtgeschlossene Mantel im Schnitt rechteckförmig ist.

12. Hochfrequenz-Plasmaquelle nach einem der Ansprüche 1 bis 11, **dadurch gekennzeichnet, daß** mehrere Anregungselektroden (3) mit einem Abstand zwischen 10 und 100 mm nebeneinander im Vakuum angeordnet sind.

13. Hochfrequenz-Plasmaquelle nach einem der Ansprüche 1 bis 12, **dadurch gekennzeichnet, daß** der Anregungselektrode (3) ein transversales Magnetfeld überlagert ist.

14. Hochfrequenz-Plasmaquelle nach Anspruch 13, **dadurch gekennzeichnet, daß** zur Erzeugung des transversalen Magnetfeldes Magnetfeldspulen (4) um das Plasmavolumen herum angeordnet sind.

15. Hochfrequenz-Plasmaquelle nach Anspruch 14, **dadurch gekennzeichnet, daß** die Magnetfeldspulen (4) außerhalb des Vakuums angeordnet sind.

16. Hochfrequenz-Plasmaquelle nach Anspruch 14, **dadurch gekennzeichnet, daß** die Magnetfeldspulen (4) innerhalb des Vakuums angeordnet sind.

17. Hochfrequenz-Plasmaquelle nach einem der Ansprüche 14 bis 16, **dadurch gekennzeichnet, daß** die Magnetfeldspulen (4) der Geometrie des Plasmavolumens angepaßt sind.

18. Hochfrequenz-Plasmaquelle nach einem der Ansprüche 14 bis 17, **dadurch gekennzeichnet, daß** die Magnetfeldspulen (4) mit Gleichstrom betrieben werden und das Magnetfeld statisch ist.

19. Hochfrequenz-Plasmaquelle nach einem der Ansprüche 14 bis 17, **dadurch gekennzeichnet, daß** die Magnetfeldspulen (4) mit Wechselstrom betrieben werden und das Magnetfeld dynamisch ist und/oder rotiert.

20. Hochfrequenz-Plasmaquelle nach Anspruch 19, **dadurch gekennzeichnet, daß** das dynamische Magnetfeld derart erzeugt wird, daß die Ströme durch benachbarte Magnetfeldspulen (4) phasenverschoben sind.

21. Hochfrequenz-Plasmaquelle nach einem der Ansprüche 1 bis 20, **dadurch gekennzeichnet, daß** die Magnetfeldspulen (4), die Anregungselektrode (3) und das Gasverteilungssystem (6) räumlich und geometrisch aufeinander abgestimmt sind.

22. Hochfrequenz-Plasmaquelle nach einem der Ansprüche 1 bis 21, **dadurch gekennzeichnet, daß** ein Extraktionssystem (5) vor der Öffnung des Plasmavolumens angeordnet ist.

23. Hochfrequenz-Plasmaquelle nach Anspruch 22, **dadurch gekennzeichnet, daß** das Extraktionssystem (5) aus einer Lochblende (13) besteht.

24. Hochfrequenz-Plasmaquelle nach Anspruch 22, **dadurch gekennzeichnet, daß** das Extraktionssystem aus einem Gitter, Netz oder Drahtgewebe (14) besteht.

25. Verwendung einer Hochfrequenz-Plasmaquelle nach einem der Ansprüche 1 bis 24 zur Erzeugung eines quasineutralen Plasmastrahls.

## Claims

1. A high frequency plasma source, comprising a support member (1) on which
- a magnetic field coil arrangement (4),
- a gas distribution system (6), and
- a unit for extracting a plasma jet (5)
are disposed,
**characterized in that** additionally a high frequency matching network (2) is located inside the plasma source, wherein capacitive or inductive plasma coupling can be chosen.

2. The high frequency plasma source according to claim 1, **characterized in that** the high frequency matching network (2) consists of a primary circuit with an arbitrary and a variable capacitor and a high frequency air-core coil, as well as a secondary circuit with a capacitor, a high frequency air-core coil, and at least one excitation electrode, wherein the circuits are coupled via the inductive flux of the high frequency air-core coils and, in addition are capacitively coupled with each other.

3. The high frequency plasma source according to any of claims 1 or 2, **characterized in that** the choice of capacitive or inductive plasma coupling can be made continuously.

4. The high frequency plasma source according to any of claims 1 to 3, **characterized in that** at least one excitation electrode (3) is disposed in vacuo.

5. The high frequency plasma source according to any of claims 1 to 4, **characterized in that** the shape, size, and disposition of the excitation electrode (3) are adapted to the geometry of the desired plasma jet.

6. The high frequency plasma source according to any of claims 1 to 5, **characterized in that** the excitation electrode (3) is plate-shaped.

7. The high frequency plasma source according to any of claims 1 to 6, **characterized in that** the excitation electrode (3) has the shape of a non-closed sheath.

8. The high frequency plasma source according to claim 7, **characterized in that** the non-closed sheath is annular in section.

9. The high frequency plasma source according to claim 7, **characterized in that** the non-closed sheath is sector-shaped in section.

10. The high frequency plasma source according to claim 7, **characterized in that** the non-closed sheath is square-shaped in section.

11. The high frequency plasma source according to claim 7, **characterized in that** the non-closed sheath is box-shaped in section.

12. The high frequency plasma source according to any of claims 1 to 11, **characterized in that** several excitation electrodes (3) are disposed in vacuo next to each other with a spacing between 10 and 100 mm.

13. The high frequency plasma source according to any of claims 1 to 12, **characterized in that** the excitation electrode (3) has a transverse magnetic field superimposed thereon.

14. The high frequency plasma source according to claim 13, **characterized in that** magnetic field coils (4) are disposed around the plasma volume for generating the transverse magnetic field.

15. The high frequency plasma source according to claim 14, **characterized in that** the magnetic field coils (4) are disposed outside the vacuum.

16. The high frequency plasma source according to claim 14, **characterized in that** the magnetic field coils (4) are disposed inside the vacuum.

17. The high frequency plasma source according to any of claims 14 to 16, **characterized in that** the magnetic field coils (4) are adapted to the geometry of the plasma volume.

18. The high frequency plasma source according to any of claims 14 to 17, **characterized in that** the magnetic field coils (4) are operated with direct current, and the magnetic field is static.

19. The high frequency plasma source according to any of claims 14 to 17, **characterized in that** the magnetic field coils (4) are operated with alternative current, and the magnetic field is dynamic and/or rotating.

20. The high frequency plasma source according to claim 19, **characterized in that** the dynamic magnetic field is generated so that the currents through neighboring magnetic field coils (4) are phase-shifted.

21. The high frequency plasma source according to any of claims 1 to 20, **characterized in that** the magnetic field coils (4), the excitation electrode (3), and the gas distribution system (6) are mutually matching in space and geometry.

22. The high frequency plasma source according to any of claims 1 to 21, **characterized in that** an extraction system (5) is disposed in front of the opening of the plasma volume.

23. The high frequency plasma source according to claim 22, **characterized in that** the extraction system (5) consists of an aperture diaphragm (13).

24. The high frequency plasma source according to claim 22, **characterized in that** the extraction system consists of a grid, a mesh, or a wire cloth (14).

25. Use of a high frequency plasma source according to any of claims 1 to 24 for generating a quasi-neutral plasma jet.

## Revendications

1. Source de plasma haute fréquence, comprenant un élément de support (1) sur lequel sont disposés
- un agencement de bobines de champ magnétique (4),
- un système de distribution de gaz (6), et
- une unité pour extraire un jet de plasma (5),
**caractérisée en ce qu'**en plus, un réseau d'adaptation haute fréquence (2) se trouve à l'intérieur de la source de plasma, dans laquelle on peut choisir entre un couplage de plasma capacitif ou inductif.

2. Source de plasma haute fréquence selon la revendication 1, **caractérisée en ce que** le réseau d'adaptation haute fréquence (2) se compose d'un circuit primaire avec un condensateur quelconque et un condensateur variable et une bobine à air haute fréquence ainsi que d'un circuit secondaire avec un condensateur, une bobine à air haute fréquence et au moins une électrode d'excitation, dans laquelle les circuits sont couplés par l'intermédiaire du flux inductif des bobines à air haute fréquence et sont en plus couplés l'un à l'autre de manière capacitive.

3. Source de plasma haute fréquence selon l'une quelconque des revendications 1 ou 2, **caractérisée en ce que** le choix entre couplage de plasma capacitif ou inductif est possible en continu.

4. Source de plasma haute fréquence selon l'une quelconque des revendications 1 à 3, **caractérisée en ce qu'**au moins une électrode d'excitation (3) est disposée sous vide.

5. Source de plasma haute fréquence selon l'une quelconque des revendications 1 à 4, **caractérisée en ce que** la forme, la dimension et la disposition de l'électrode d'excitation (3) sont adaptées à la géométrie du jet de plasma souhaité.

6. Source de plasma haute fréquence selon l'une quelconque des revendications 1 à 5, **caractérisée en ce que** l'électrode d'excitation (3) se présente sous forme de plaque.

7. Source de plasma haute fréquence selon l'une quelconque des revendications 1 à 6, **caractérisée en ce que** l'électrode d'excitation (3) se présente sous forme d'enveloppe non fermée.

8. Source de plasma haute fréquence selon la revendication 7, **caractérisée en ce que** l'enveloppe non fermée est annulaire en section transversale.

9. Source de plasma haute fréquence selon la revendication 7, **caractérisée en ce que** l'enveloppe non fermée est de forme sectorielle en section transversale.

10. Source de plasma haute fréquence selon la revendication 7, **caractérisée en ce que** l'enveloppe non fermée est de forme carrée en section transversale.

11. Source de plasma haute fréquence selon la revendication 7, **caractérisée en ce que** l'enveloppe non fermée est de forme rectangulaire en section transversale.

12. Source de plasma haute fréquence selon l'une quelconque des revendications 1 à 11, **caractérisée en ce que** plusieurs électrodes d'excitation (3) sont disposées sous vide les unes à côté des autres à un espacement entre 10 et 100 mm.

13. Source de plasma haute fréquence selon l'une quelconque des revendications 1 à 12, **caractérisée en ce qu'**un champ magnétique transversal est superposé à l'électrode d'excitation (3).

14. Source de plasma haute fréquence selon la revendication 13, **caractérisée en ce que** pour générer le champ magnétique transversal, les bobines de champ magnétique (4) sont disposées autour du volume de plasma.

15. Source de plasma haute fréquence selon la revendication 14, **caractérisée en ce que** les bobines de champ magnétique (4) sont disposées à l'extérieur du vide.

16. Source de plasma haute fréquence selon la revendication 14, **caractérisée en ce que** les bobines de champ magnétique (4) sont disposées à l'intérieur du vide.

17. Source de plasma haute fréquence selon l'une quelconque des revendications 14 à 16, **caractérisée en ce que** les bobines de champ magnétique (4) sont adaptées à la géométrie du volume de plasma.

18. Source de plasma haute fréquence selon l'une quelconque des revendications 14 à 17, **caractérisée en ce que** les bobines de champ magnétique (4) fonctionnent avec du courant continu et le champ magnétique est statique.

19. Source de plasma haute fréquence selon l'une quelconque des revendications 14 à 17, **caractérisée en ce que** les bobines de champ magnétique (4) fonctionnent avec du courant alternatif et le champ magnétique est dynamique et/or tournant.

20. Source de plasma haute fréquence selon la revendication 19, **caractérisée en ce que** le champ magnétique dynamique est généré de telle sorte que les courants à travers les bobines de champ magnétique (4) voisines sont déphasés.

21. Source de plasma haute fréquence selon l'une quelconque des revendications 1 à 20, **caractérisée en ce que** les bobines de champ magnétique (4), l'électrode d'excitation (3) et le système de distribution de gaz (6) sont adaptés les uns aux autres au niveau spatial et géométrique.

22. Source de plasma haute fréquence selon l'une quelconque des revendications 1 à 21, **caractérisée en ce qu'**un système d'extraction (5) est disposé devant l'ouverture du volume de plasma.

23. Source de plasma haute fréquence selon la revendication 22, **caractérisée en ce que** le système d'extraction (5) se compose d'un diaphragme à trou (13).

24. Source de plasma haute fréquence selon la revendication 22, **caractérisée en ce que** le système d'extraction se compose d'une grille, d'un treillis ou d'un tissu métallique (14).

25. Utilisation d'une source de plasma haute fréquence selon l'une quelconque des revendications 1 à 24 pour générer un jet de plasma quasi neutre.
